# EUROPEAN PATENT APPLICATION

(11) **EP 4 632 810 A1**
(43) Date of publication of application: **15.10.2025**
(21) Application number: 25165200.4
(22) Date of filing: 21.03.2025
(51) Int. Cl.: H01L 23/498, H01L 23/31

(54) **SEMICONDUCTOR PACKAGE DEVICE AND METHOD OF MANUFACTURING THE SAME**

(30) Priority: 28.03.2024 KR 20240042170; 05.02.2025 KR 20250014702
(71) Applicant: Silicon Box Pte. Ltd., Singapore 529580 (SG)
(72) Inventor: HAN, Byung Joon, 06067 SEOUL (KR); HAN, Young Michael, NEW YORK, 10010 (US); AHN, Byung Hoon, 16941 GYEONGGI-DO (KR)
(74) Representative: Cabinet Beaumont

(57) **Abstract**

Disclosed are a semiconductor package device and a method of manufacturing the same. The semiconductor package device includes a redistribution layer member having at least one electrical contact element around an active region, at least one chip disposed on a first surface of the redistribution layer member, the chip being electrically connected to the redistribution layer member, a molding layer disposed on the first surface of the redistribution layer member so as to expose a backside of the chip while filling a space around the chip, the molding layer having at least one through-hole configured to expose the electrical contact element, and a connection wiring member disposed on the molding layer, the connection wiring member being configured to be electrically connected to the electrical contact element through the through-hole and to be electrically connected to the backside of the chip.

## Description

### CROSS-REFERENCE TO RELATED APPLICATIONS

This application claims priority to Korean Patent Application No. 10-2024-0042170, filed on March 28, 2024, and Korean Patent Application No. 10-2025-0014702, filed on February 5, 2025, the entire contents of which are herein incorporated by reference.

### BACKGROUND OF THE INVENTION

### 1. Field of the invention

The present invention relates to a semiconductor device/electronic device and a method of manufacturing the same, and more particularly to a semiconductor package device and a method of manufacturing the same.

### 2. Description of the Related Art

A semiconductor process may be divided into a front-end process of manufacturing a wafer and engraving a circuit and a back-end process of packaging a chip. As semiconductor miniaturization technology approaches its limits in recent years, importance of the back-end process is further increasing.

The existing packaging of a semiconductor chip, such as a metal-oxide-semiconductor field-effect transistor (MOSFET) chip, may include a step of attaching the chip to a lead frame, a step of forming an electrical connection structure for the chip by wire bonding or clip bonding, and a molding step. Existing packaging requires handling and processing of various materials to satisfy power, ground, or drain requirements and a heat dissipation function. In addition, existing packaging is performed for each individual chip, and thus has a problem of greatly reduced process efficiency.

Recently, as new chip manufacturing technologies have been developed, various new technologies have been proposed in terms of chip connection and power supply. For example, a backside power delivery network (BSPDN) structure that supplies power through a backside of a semiconductor chip rather than a frontside of the semiconductor chip has been proposed, and a technology that stacks a plurality of semiconductor chips through a connection structure such as a through silicon via (TSV) has been proposed. However, there is a lack of technology capable of improving process efficiency while ensuring electrical connection and heat dissipation performance in terms of semiconductor packaging.

### SUMMARY OF THE INVENTION

It is an object of the present invention to provide a semiconductor package device capable of improving electrical and thermal performance while increasing manufacturing efficiency and a method of manufacturing the same.

It is another object of the present invention to provide a semiconductor package device capable of reducing material costs and process time and increasing productivity while improving electrical and thermal performance and a method of manufacturing the same.

Objects of the present invention are not limited to the aforementioned objects, and other unmentioned objects will be understood by those skilled in the art based on the following description.

In accordance with one aspect of the present invention, the above and other objects can be accomplished by the provision of a semiconductor package device including a redistribution layer member having at least one electrical contact element around an active region, at least one chip disposed on a first surface of the redistribution layer member, the at least one chip being electrically connected to the redistribution layer member, a molding layer disposed on the first surface of the redistribution layer member so as to expose a backside of the at least one chip while filling a space around the at least one chip, the molding layer having at least one through-hole configured to expose the at least one electrical contact element, and a connection wiring member disposed on the molding layer, the connection wiring member being configured to be electrically connected to the at least one electrical contact element through the at least one through-hole and to be electrically connected to the backside of the at least one chip.

The at least one electrical contact element may include a stacked via structure.

The at least one electrical contact element may have characteristics of a power wire, a ground wire, or a drain wire.

The at least one electrical contact element may be a single electrical contact element, and the single electrical contact element may have a ring structure surrounding the active region.

The at least one electrical contact element may include a plurality of electrical contact elements disposed around the active region so as to be spaced apart from each other.

The backside of the chip and the surface of the molding layer may be disposed on the same plane.

The through-hole may be formed so as to extend to a part of the redistribution layer member while being formed through the molding layer.

The connection wiring member may have characteristics of a power wire, a ground wire, or a drain wire.

The connection wiring member may be configured to have heat dissipation characteristics.

The connection wiring member may be provided in plural.

A plurality of electrical connection elements may be disposed on a second surface of the redistribution layer member, the second surface being opposite the first surface.

The semiconductor package device may have a fan-out package structure.

In accordance with another aspect of the present invention, there is provided a method of manufacturing a semiconductor package device, the method including preparing a device structure including a redistribution layer member, a plurality of chips, and a molding layer, wherein the redistribution layer member has a plurality of unit device regions and has at least one electrical contact element around an active region for each of the plurality of unit device regions, the plurality of chips is disposed on a first surface of the redistribution layer member so as to be electrically connected to the redistribution layer member, the molding layer is disposed on the first surface of the redistribution layer member so as to expose a backside of each of the plurality of chips while filling spaces around the plurality of chips and has at least one through-hole configured to expose the at least one electrical contact element for each of the plurality of unit device regions, forming a connection wiring member electrically connected to the at least one electrical contact element through the at least one through-hole and electrically connected to the backside of at least one of the plurality of chips on the molding layer for each of the plurality of unit device regions, and dividing the device structure having the connection wiring member formed therein into package device units corresponding respectively to the plurality of unit device regions.

The at least one electrical contact element may include a stacked via structure.

The at least one electrical contact element may have characteristics of a power wire, a ground wire, or a drain wire.

The at least one electrical contact element may be a single electrical contact element for each of the plurality of unit device regions, and the single electrical contact element may have a ring structure surrounding the active region.

The at least one electrical contact element may include a plurality of electrical contact elements disposed around the active region so as to be spaced apart from each other for each of the plurality of unit device regions.

The backside of the chip and the surface of the molding layer may be disposed on the same plane.

In the step of preparing the device structure, an initial molding layer configured to cover the plurality of chips may be formed, and a grinding or ablation process may be performed on the initial molding layer to expose the backside of each of the plurality of chips.

The connection wiring member may be formed using any one of a sputtering method, a coating method, and a plating method.

The connection wiring member may have characteristics of a power wire, a ground wire, or a drain wire.

A plurality of electrical connection elements may be formed on a second surface of the redistribution layer member, the second surface being opposite the first surface.

The semiconductor package device may be manufactured using a fan-out packaging method.

### BRIEF DESCRIPTION OF THE DRAWINGS

FIG. 1 is a sectional view illustratively showing a semiconductor package device according to an embodiment of the present invention;
FIG. 2 is a plan view illustratively describing the configuration of a redistribution layer member that can be applied to the semiconductor package device according to the embodiment of the present invention;
FIG. 3 is a plan view illustratively describing the configuration of a redistribution layer member that can be applied to a semiconductor package device according to another embodiment of the present invention;
FIG. 4 is a sectional view illustratively showing a semiconductor package device according to another embodiment of the present invention;
FIG. 5 is a sectional view illustratively showing a semiconductor package device according to another embodiment of the present invention;
FIG. 6 is a sectional view illustratively showing a semiconductor package device according to another embodiment of the present invention; and
FIGs. 7A to 7E are sectional views illustratively showing a method of manufacturing a semiconductor package device according to an embodiment of the present invention.

### DETAILED DESCRIPTION OF THE PREFERRED EMBODIMENTS

Hereinafter, embodiments of the present invention will be described in detail with reference to the accompanying drawings. The sizes or thicknesses of regions or parts shown in the accompanying drawings may be somewhat exaggerated for clarity and ease of description. Throughout the detailed description, the same reference symbols denote the same components.

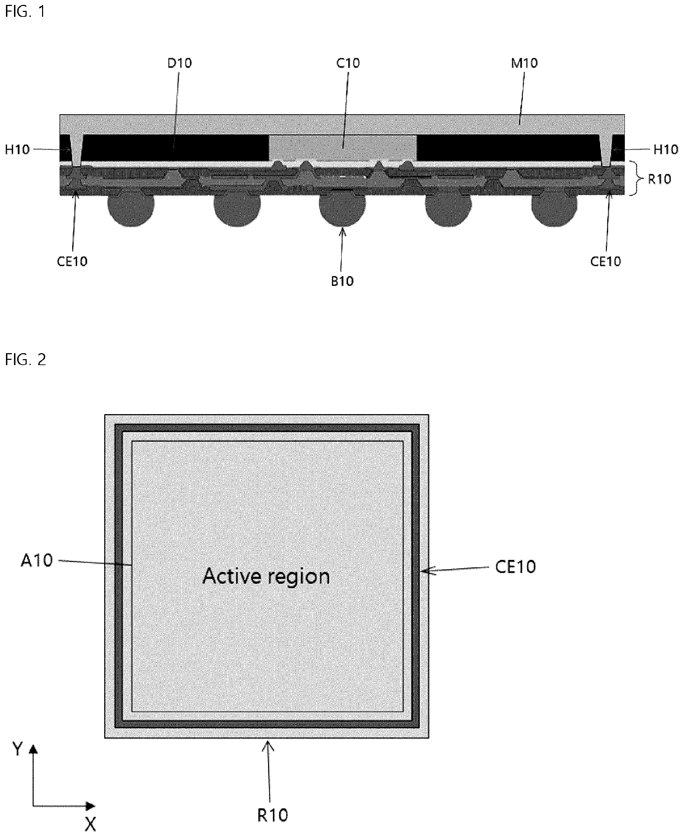

FIG. 1 is a sectional view illustratively showing a semiconductor package device according to an embodiment of the present invention.

Referring to FIG. 1, the semiconductor package device according to the embodiment of the present invention may include a redistribution layer (RDL) member R10, at least one chip (die) C10, a molding layer D10, and a connection wiring member M10.

The redistribution layer member R10 may serve to redistribute an electrode pad array of the chip C10. The redistribution layer member R10 may be formed through processes such as forming an insulating layer having a via hole (opening), forming a seed layer, forming a mask pattern, electroplating a wiring layer, and removing the mask pattern. The redistribution layer member R10 may include a structure in which an insulating layer (e.g., an organic insulating layer) and a wiring member layer (wiring element layer) are alternately stacked at least once. The insulating layer may have a plurality of via holes (openings) formed therein, and conductive via elements may be provided in the via holes. The conductive via element may serve as a vertical wire. The conductive via element may also be referred to as a "via-type wire" or a "via plug." The insulating layer in direct contact with the chip C10 may also be referred to as a passivation layer. The passivation layer may be considered to be included in the redistribution layer member R10, but this may not be the case.

The redistribution layer member R10 may have at least one electrical contact element CE10 around an active region. The electrical contact element CE10 may be disposed around the active region, and in this regard, the electrical contact element may be referred to as a "surrounding electrical contact element" or a "surrounding contact element."

At least one chip C10 may be disposed on a first surface of the redistribution layer member R10 so as to be electrically connected to the redistribution layer member R10. Here, the case where one chip C10 is provided is shown. The chip C10 may be a semiconductor chip, and may also be referred to as a die. Electrode pads formed on a frontside (front surface) of the chip C10 may be disposed so as to face the redistribution layer member R10. The first surface of the redistribution layer member R10 may be any one of two main surfaces (an upper surface and a lower surface) of the redistribution layer member R10.

The molding layer D10 may be disposed on the first surface of the redistribution layer member R10 so as to surround the perimeter of the chip C10. The molding layer D10 may be disposed on the first surface of the redistribution layer member R10 so as to expose a backside (back surface) of the chip C10 while filling a space around the chip C10. The backside of the chip C10 may not be covered by the molding layer D10. The molding layer D10 may include a polymer material. For example, the molding layer D10 may include a molding compound.

The molding layer D10 may be provided with at least one through-hole H10 formed so as to expose the at least one electrical contact element CE10 of the redistribution layer member R10. The through-hole H10 may be a vertical hole or a type of via hole. The through-hole H10 may be referred to as a through mold via (TMV). As needed, a plurality of through-holes H10 may be formed. The through-hole H10 may be formed through an optical drilling or mechanical drilling process. As an example, the through-hole H10 may be formed by a drilling process using a laser. The through-hole H10 may be formed so as to extend to a part of the redistribution layer member R10 while being formed through the molding layer D10. On the assumption that an intermediate layer (passivation layer) is present between the redistribution layer member R10 and the molding layer D10, the through-hole H10 may be formed through the intermediate layer (passivation layer) while being formed through the molding layer D10.

The connection wiring member M10 may be disposed on the molding layer D10. The connection wiring member M10 may be configured to be electrically connected to the at least one electrical contact element CE10 through the at least one through-hole H10 and to be electrically connected to the backside of the at least one chip C10. The through-hole H10 may be filled with a material (conductive material) of the connection wiring member M10. The connection wiring member M10 may be in direct contact with the electrical contact element CE10, and may also be in direct contact with the backside of the chip C10. At least one electrode pad may be present on the backside of the chip C10, and the connection wiring member M10 may be electrically connected to (in electric contact with) the electrode pad on the backside of the chip C10.

The connection wiring member M10 may be made of a metal or a metallic material. As an example, the connection wiring member M10 may be made of Cu or may include Cu as a major constituent material. However, the material of the connection wiring member M10 is not limited to Cu and may be varied. Any general wiring material (conductive material) may be applied to the connection wiring member M10. The connection wiring member M10 may be formed by backside metallization. The connection wiring member M10 may be referred to as a "connection wiring layer" or a "connection wiring pattern."

A plurality of electrical connection elements B10 may be disposed on a second surface of the redistribution layer member R10, which is opposite the first surface. Here, the second surface may be any one of the two main surfaces (the upper surface and the lower surface) of the redistribution layer member R10. As a non-limiting example, each of the plurality of electrical connection elements B10 may include a solder ball or a bump. According to an example, the plurality of electrical connection elements B10 may be attached to an under bump metallurgy (UBM) layer. The plurality of electrical connection elements B10 may be connected to a predetermined circuit board.

The electrical contact element CE10 of the redistribution layer member R10 may be electrically connected to at least one of the plurality of electrical connection elements B10 by a wiring structure of the redistribution layer member R10. As a result, at least one of the plurality of electrical connection elements B10 may be electrically connected to the backside of the chip C10 via the electrical contact element CE10 and the connection wiring member M10.

The semiconductor package device according to the embodiment of the present invention may have a fan-out package structure. In other words, the overall size (width) of the semiconductor package device may be greater than the size (width) of the chip C10, and the plurality of electrical connection elements B10 may be disposed so as to exceed the size of the chip C10. The semiconductor package device may be manufactured using panel-level packaging (PLP) or wafer-level packaging (WLP).

According to an embodiment, at least one electrical contact element CE10 may include a stacked via structure. In other words, the electrical contact element CE10 may include a structure in which a plurality of via plugs is stacked in a vertical direction. In addition, the electrical contact element CE10 may include a via land for contact, i.e., a via extension portion.

According to an embodiment, at least one electrical contact element CE10 may have the characteristics (function) of a power wire, a ground wire, or a drain wire. Similarly, the connection wiring member M10 connected to the electrical contact element CE10 may have the characteristics (function) of a power wire, a ground wire, or a drain wire. If the connection wiring member M10 has the characteristics (function) of a power wire, power may be supplied to the chip C10 through the connection wiring member M10. However, the functions of the electrical contact element CE10 and the connection wiring member M10 are not limited thereto, and may be selected from among various functions according to purpose.

In addition, the electrical contact element CE10 may be used as a kind of thermal path. Furthermore, the connection wiring member M10 may be configured to have heat dissipation characteristics. That is, the connection wiring member M10 may function as a heat dissipation member. If the connection wiring member M10 is made of a metal or a metallic material having excellent thermal conductivity, the connection wiring member may function as an excellent heat dissipation member. Therefore, heat generated from the chip C10 or the redistribution layer member R10 may be easily dissipated through the connection wiring member M10, whereby the thermal and electrical performance of the semiconductor package device may be improved.

According to an embodiment, the backside of the chip C10 and the surface of the molding layer D10 may be disposed on the same plane. In other words, the backside of the chip C10 and the surface of the molding layer D10 may be disposed to form substantially the same plane at substantially the same height. For example, after forming an initial molding layer covering the chip C10, a grinding or ablation process may be performed on the initial molding layer to expose the backside of the chip C10. The backside of the chip C10 and the surface of the molding layer D10 may be disposed on substantially the same plane, and the connection wiring member M10 may be formed on a substantially flat surface in the region other than the through-hole H10.

FIG. 2 is a plan view illustratively describing the configuration of a redistribution layer member that can be applied to the semiconductor package device according to the embodiment of the present invention.

Referring to FIG. 2, the redistribution layer member R10 that can be applied to the semiconductor package device according to the embodiment of the present invention may have an active region A10, and may be provided with at least one electrical contact element CE10 around the active region A10. The electrical contact element CE10 may be referred to as a "surrounding electrical contact element" or a "surrounding contact element."

In this embodiment, the at least one electrical contact element CE10 may be a single electrical contact element. The electrical contact element CE10 corresponding to the single electrical contact element may have a ring structure surrounding the active region A10, when viewed from above. The electrical contact element CE10 may have a seal ring structure that completely surrounds the active region A10. For example, the electrical contact element CE10 may have a quadrangular ring structure, a similar structure thereto, or a modified structure thereof.

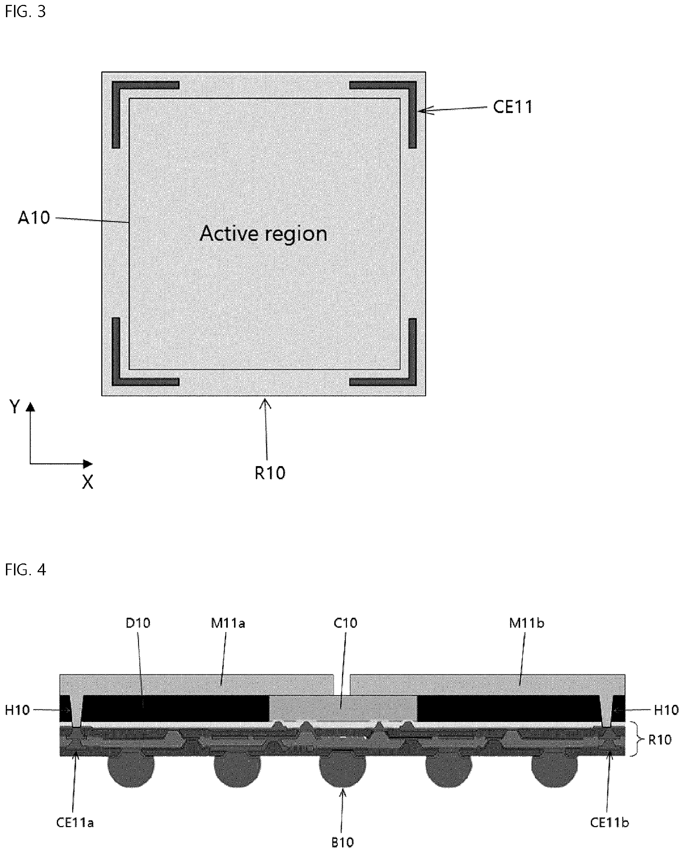

FIG. 3 is a plan view illustratively describing the configuration of a redistribution layer member that can be applied to a semiconductor package device according to another embodiment of the present invention.

Referring to FIG. 3, the redistribution layer member R10 may include a plurality of electrical contact elements CE11 disposed around an active region A10 so as to be spaced apart from each other. The plurality of electrical contact elements CE11 may be configured to partially surround the active region A10. The position, shape, and number of the plurality of electrical contact elements CE11 are illustrative and may be varied. One or more electrical contact elements CE11 may be formed at selected positions in an allowable region (space) around the active region A10.

The connection wiring member M10 described with reference to FIG. 1 may have a shape that entirely or partially covers the active region A10. The connection wiring member M10 may have a shape that approximately entirely or partially covers one surface of the semiconductor package device. For example, the connection wiring member M10 may have a quadrangular pad shape, a line pattern shape, or any other pattern shape.

FIG. 4 is a sectional view illustratively showing a semiconductor package device according to another embodiment of the present invention. The semiconductor package device according to this embodiment has a structure in which a part of the structure of FIG. 1 is modified. The modified structure will be described with reference to FIG. 4.

Referring to FIG. 4, the redistribution layer member R10 may include first and second electrical contact elements CE11a and CE11b disposed around the active region so as to be spaced apart from each other. A plurality of connection wiring members M11a and M11b may be provided on the molding layer D10. The plurality of connection wiring members M11a and M11b may include a first connection wiring member M11a and a second connection wiring member M11b. The first and second connection wiring members M11a and M11b may be physically spaced apart (separated) from each other. In addition, the first and second connection wiring members M11a and M11b may be electrically spaced apart (separated) from each other. The first connection wiring member M11a may be configured to be electrically connected to the first electrical contact element CE11a and the backside of the chip C10. The second connection wiring member M11b may be configured to be electrically connected to the second electrical contact element CE11b and the backside of the chip C10. The first and second connection wiring members M11a and M11b may have different functions.

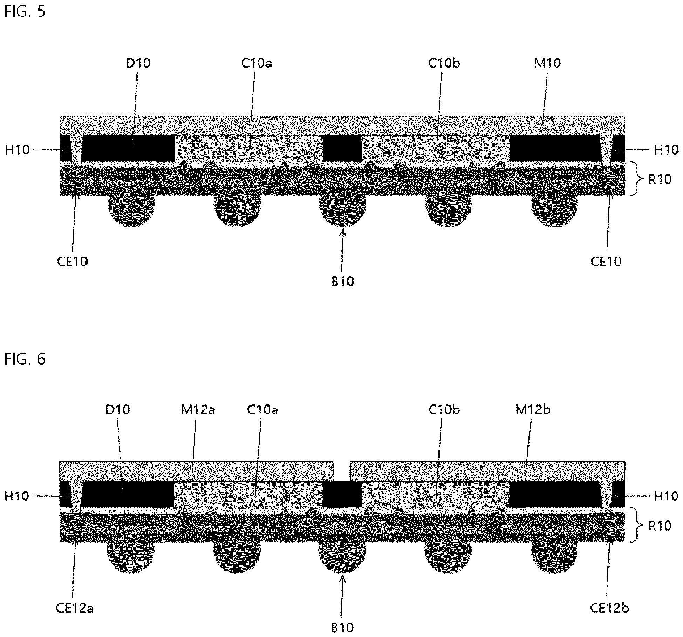

FIGs. 1 and 4 show the case where the semiconductor package device includes one chip (a single chip), but a semiconductor package device according to another embodiment may include a plurality of chips (multiple chips). The case where the semiconductor package device includes a plurality of chips (multiple chips) is shown in FIGs. 5 and 6.

FIG. 5 is a sectional view illustratively showing a semiconductor package device according to another embodiment of the present invention.

Referring to FIG. 5, the semiconductor package device according to this embodiment may include a plurality of chips C10a and C10b disposed on a first surface of a redistribution layer member R10. The plurality of chips C10a and C10b may include two or more chips. A molding layer D10 may be disposed on the first surface of the redistribution layer member R10 so as to fill spaces around the plurality of chips C10a and C10b. A connection wiring member M10 electrically connected to a backside of at least one of the plurality of chips C10a and C10b while being electrically connected to at least one electrical contact element CE10 may be disposed on the molding layer D10.

FIG. 6 is a sectional view illustratively showing a semiconductor package device according to another embodiment of the present invention. The semiconductor package device according to this embodiment has a structure in which a part of the structure of FIG. 5 is modified.

Referring to FIG. 6, the redistribution layer member R10 may include first and second electrical contact elements CE12a and CE12b disposed around the active region so as to be space apart from each other. The plurality of chips C10a and C10b may include a first chip C10a and a second chip C10b. A plurality of connection wiring members M12a and M12b may be provided on the molding layer D10. The plurality of connection wiring members M12a and M12b may include a first connection wiring member M12a and a second connection wiring member M12b. The first and second connection wiring members M12a and M12b may be physically spaced apart (separated) from each other. In addition, the first and second connection wiring members M12a and M12b may be electrically spaced apart (separated) from each other. The first connection wiring member M12a may be configured to be electrically connected to the first electrical contact element CE12a and to the backside of the first chip C10a. The second connection wiring member M12b may be configured to be electrically connected to the second electrical contact element CE12b and the backside of the second chip C10b. The first and second connection wiring members M12a and M12b may have the same function or different functions.

According to the embodiment of the present invention, for example, in a fan-out semiconductor package, a redistribution layer member is provided with a predetermined electrical contact element, and a connection wiring member connected to the electrical contact element and a backside of a chip is formed on a molding layer exposing the backside of the chip through backside metallization, whereby it is possible to improve electrical and thermal performance while significantly improving process efficiency. The connection wiring member formed through backside metallization may replace the function of, for example, the existing wire bonding or clip bonding.

The existing packaging may include a step of attaching a chip to a lead frame, a step of forming an electrical connection structure for the chip by wire bonding or clip bonding, and a molding step. The existing packaging requires various material handling and processes to satisfy power, ground, or drain requirements and a heat dissipation function. In addition, the existing packaging is performed for each individual chip, and thus has a problem of greatly reduced process efficiency. The embodiment of the present invention may overcome the disadvantages of the existing packaging. According to the embodiment of the present invention, it is possible to implement a semiconductor package device capable of reducing material costs and process time and increasing productivity while improving electrical and thermal performance and a method of manufacturing the same.

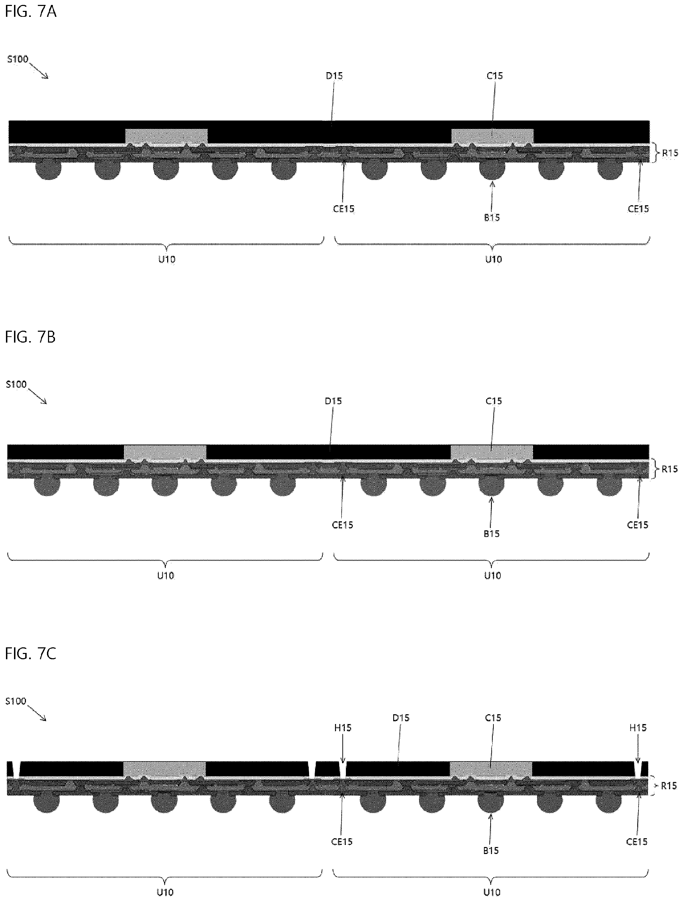

FIGs. 7A to 7E are sectional views illustratively showing a method of manufacturing a semiconductor package device according to an embodiment of the present invention.

Referring to FIG. 7A, a device structure S100 including a redistribution layer member R15, a plurality of chips C15, and a molding layer D15 may be prepared. The device structure S100 may be formed using fan-out packaging. For example, the device structure S100 may be formed using fan-out panel level packaging (FOPLP) or fan-out wafer level packaging (FOWLP). As a specific example, a plurality of chips C15 may be attached to a predetermined carrier substrate, a molding layer D15 covering the plurality of chips C15 may be formed on the carrier substrate, the plurality of chips C15 and the molding layer D15 may be separated from the carrier substrate, and a redistribution layer member R15 electrically connected to the plurality of chips C15 may be formed. The plurality of chips C15 may be attached to the carrier substrate, for example, in a face-down manner. In addition, when forming the device structure S100, a chip-first (i.e., die-first) method or a chip-last (i.e., die-last) method may be applied.

The redistribution layer member R15 may be formed through processes such as forming an insulating layer having a via hole (opening), forming a seed layer, forming a mask pattern, electroplating a wiring layer, and removing the mask pattern. The redistribution layer member R15 may include a structure in which an insulating layer (e.g., an organic insulating layer) and a wiring member layer (wiring element layer) are alternately stacked at least once. The insulating layer may have a plurality of via holes (openings) formed therein, and conductive via elements may be provided in the via holes. The conductive via element may serve as a vertical wire. The insulating layer in direct contact with the chip C15 may also be referred to as a passivation layer. The passivation layer may be considered to be included in the redistribution layer member R15, but this may not be the case.

The redistribution layer member R15 may have a plurality of unit device regions U10. The plurality of unit device regions U10 may be two-dimensionally disposed. The redistribution layer member R15 may have at least one electrical contact element CE15 around an active region for each of the plurality of unit device regions U10. The electrical contact element CE15 may be disposed around the active region, and therefore the electrical contact element may be referred to as a "surrounding electrical contact element" or a "surrounding contact element."

The plurality of chips C15 may be disposed on a first surface of the redistribution layer member R15 so as to be electrically connected to the redistribution layer member R15. At least one chip C15 may be disposed in each of the plural unit device regions U10. Here, the case in which one chip C15 is provided in one unit device region U10 is shown. Electrode pads formed on a frontside (front surface) of the chip C15 may be disposed so as to face the redistribution layer member R15.

The molding layer D15 may be disposed on the first surface of the redistribution layer member R15 so as to surround the perimeters of the plurality of chips C15. The molding layer D15 may be formed on the first surface of the redistribution layer member R15 so as to cover the plurality of chips C15. The height of the molding layer D15 may be greater than the height of the chip C15. Consequently, a side surface and a backside of the chip C15 may be covered by the molding layer D15. The molding layer D15 may include a polymer material. For example, the molding layer D15 may include a molding compound.

According to an example, a plurality of electrical connection elements B15 may be formed (disposed) on a second surface of the redistribution layer member R15, which is opposite the first surface. As a non-limiting example, each of the plurality of electrical connection elements B15 may include a solder ball or a bump. The plurality of electrical connection elements B15 may be attached to an under bump metallurgy (UBM) layer. In some cases, the time of formation of the plurality of electrical connection elements B15 may be varied.

Referring to FIG. 7B, a grinding or ablation process may be performed on the molding layer D15 to expose the backside of each of the plurality of chips C15. The molding layer D15 formed so as to cover the plurality of chips C15 in the step of FIG. 7A may be referred to as an initial molding layer, and the backside of each of the plurality of chips C15 may be exposed through the grinding or ablation process for the initial molding layer. However, in some cases, the molding process may be performed such that the backside of the chip C15 is exposed. In other words, the molding layer may be formed in the same shape as shown in FIG. 7B from the beginning. In this case, processes such as grinding or ablation may not be required.

In this step, the molding layer D15 may be disposed on the first surface of the redistribution layer member R15 so as to expose the backside of each of the plurality of chips C15 while filling spaces around the plurality of chips C15. The backside of the chip C15 may be exposed without being covered by the molding layer D15. The backside of the chip C15 and the surface of the molding layer D15 may be disposed on the same plane. In other words, the backside of the chip C15 and the surface of the molding layer D15 may be disposed to form substantially the same plane at substantially the same height.

Referring to FIG. 7C, at least one through-hole H15 configured to expose at least one electrical contact element CE15 for each of the plurality of unit device regions U10 may be formed in the molding layer D15. A plurality of through-holes H15 may be formed. The through-hole H15 may be a vertical hole or a type of via hole. The through-hole H15 may be referred to as a through mold via (TMV). The through-hole H15 may be formed through an optical drilling or mechanical drilling process. As an example, the through-hole H15 may be formed by a drilling process using a laser. The through-hole H15 may be formed so as to extend to a part of the redistribution layer member R15 while being formed through the molding layer D150. On the assumption that an intermediate layer (passivation layer) is present between the redistribution layer member R15 and the molding layer D15, the through-hole H15 may be formed through the intermediate layer (passivation layer) while being formed through the molding layer D15.

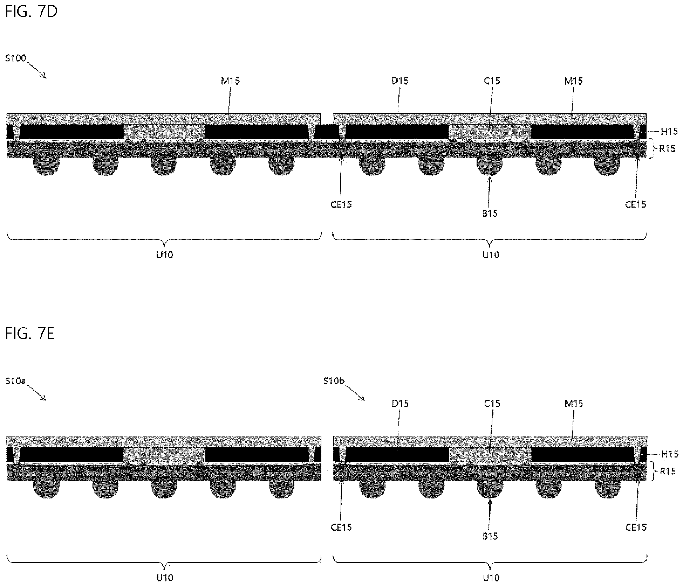

Referring to FIG. 7D, a connection wiring member M15 may be formed on the molding layer D15 for each of the plurality of unit device regions U10. In each of a plurality of unit device regions U10, the connection wiring member M15 may be configured to be electrically connected to the at least one electrical contact element CE15 through the at least one through-hole H15 and to be electrically connected to the backside of at least one of the plurality of chips C15. The through-hole H15 may be filled with a material (conductive material) of the connection wiring member M15. The connection wiring member M15 may be in direct contact with the electrical contact element CE15, and may also be in direct contact with the backside of the chip C15. At least one electrode pad may be present on the backside of the chip C15, and the connection wiring member M15 may be electrically connected to (in electric contact with) the electrode pad on the backside of the chip C15.

The connection wiring member M15 may be made of a metal or a metallic material. As an example, the connection wiring member M15 may be made of Cu or may include Cu as a major constituent material. However, the material of the connection wiring member M15 is not limited to Cu and may be varied. Any general wiring material (conductive material) may be applied to the connection wiring member M15. The connection wiring member M15 may be formed by backside metallization.

The connection wiring member M15 may be formed using, for example, any one of a sputtering method, a coating method, and a plating method. In forming the connection wiring member M15, a damascene process may be employed if necessary. However, the specific method of forming the connection wiring member M15 is not limited thereto and may be varied depending on the circumstances.

Referring to FIG. 7E, the device structure S100 (FIG. 7D) in which the connection wiring member M15 is formed may be divided (cut) into package device units corresponding respectively to the plurality of unit device regions U10. This may be performed according to a general dividing (cutting) method. As a result, individual semiconductor package devices S10a and S10b may be obtained. Each of the semiconductor package devices S10a and S10b may have the configuration described with reference to FIG. 1.

According to an embodiment, at least one electrical contact element CE15 may include, for example, a stacked via structure. For each of the plurality of unit device regions U10, the at least one electrical contact element CE15 may be a single electrical contact element, and the single electrical contact element may have a ring structure surrounding the active region (see FIG. 2). Alternatively, for each of the plurality of unit device regions U10, the at least one electrical contact element CE15 may include a plurality of electrical contact elements disposed around the active region so as to be spaced apart from each other (see FIG. 3).

According to an embodiment, the at least one electrical contact element CE15 may have the characteristics of a power wire, a ground wire, or a drain wire. In addition, the at least one electrical contact element CE15 may be used as a thermal path. The connection wiring member M15 may have the characteristics of a power wire, a ground wire, or a drain wire. In addition, the connection wiring member M15 may function as a heat dissipation member.

Additionally, a plurality of connection wiring members may be formed for each of the plurality of unit device regions U10 (see FIGs. 4 and 6). In addition, a plurality of chips may be disposed in each of the plurality of unit device areas U10 (see FIGs. 5 and 6). Furthermore, all of the features described with reference to FIGs. 1 to 6 may be applied to the method of manufacturing the semiconductor package device according to the embodiment of the present invention.

According to the embodiments of the present invention described above, it is possible to implement a semiconductor package device capable of improving electrical and thermal performance while increasing manufacturing efficiency and a method of manufacturing the same. In addition, according to the embodiments of the present invention, it is possible to implement a semiconductor package device capable of reducing material costs and process time and increasing productivity while improving electrical and thermal performance and a method of manufacturing the same.

According to an embodiment, for example, in a fan-out semiconductor package, a redistribution layer member is provided with a predetermined electrical contact element, and a connection wiring member connected to the electrical contact element and a backside of a chip is formed on a molding layer exposing the backside of the chip through backside metallization, whereby it is possible to improve electrical and thermal performance while significantly improving process efficiency. Here, the connection wiring member formed through backside metallization may replace the function of, for example, the existing wire bonding or clip bonding.

The technology according to the embodiments of the present invention may be applied to a panel level package (PLP) or a wafer level package (WLP), and may also be applied to a single chip (die) package or a multi-chip (multi-die) package. The technology according to the embodiments may be usefully applied to various advanced packaging fields.

However, the effects of the present invention are not limited to the above effects, and may be variously expanded without departing from the technical ideas and scope of the present invention.

Preferred embodiments of the present invention have been disclosed herein, and although certain terms are used, they are used in a general sense to facilitate the description and understanding of the invention, and are not intended to limit the scope of the invention. In addition to the embodiments disclosed herein, other modifications based on the technical ideas of the present invention will be apparent to those skilled in the art to which the present invention pertains. It will be apparent to those skilled in the art that the semiconductor package device and the method of manufacturing the same according to the embodiments described with reference to FIGs. 1 to 7E may be subject to various substitutions, changes, and modifications without departing from the technical ideas of the present invention. The scope of the invention is therefore not to be defined by the embodiments described above but by the technical ideas recited in the appended claims.

## Claims

1. A semiconductor package device comprising:
a redistribution layer member having at least one electrical contact element around an active region;
at least one chip disposed on a first surface of the redistribution layer member, the at least one chip being electrically connected to the redistribution layer member;
a molding layer disposed on the first surface of the redistribution layer member so as to expose a backside of the at least one chip while filling a space around the at least one chip, the molding layer having at least one through-hole configured to expose the at least one electrical contact element; and
a connection wiring member disposed on the molding layer, the connection wiring member being configured to be electrically connected to the at least one electrical contact element through the at least one through-hole and to be electrically connected to the backside of the at least one chip.

2. The semiconductor package device according to claim **1,** wherein the at least one electrical contact element comprises a stacked via structure.

3. The semiconductor package device according to claim 1, wherein the at least one electrical contact element has characteristics of a power wire, a ground wire, or a drain wire.

4. The semiconductor package device according to claim 1, wherein
the at least one electrical contact element is a single electrical contact element, and
the single electrical contact element has a ring structure surrounding the active region.

5. The semiconductor package device according to claim 1, wherein the at least one electrical contact element comprises a plurality of electrical contact elements disposed around the active region so as to be spaced apart from each other.

6. The semiconductor package device according to claim 1, wherein the backside of the chip and a surface of the molding layer are disposed on the same plane.

7. The semiconductor package device according to claim 1, wherein the through-hole is formed so as to extend to a part of the redistribution layer member while being formed through the molding layer.

8. The semiconductor package device according to claim 1, wherein the connection wiring member has characteristics of a power wire, a ground wire, or a drain wire.

9. The semiconductor package device according to claim 1, wherein the connection wiring member is configured to have heat dissipation characteristics.

10. The semiconductor package device according to claim 1, wherein the connection wiring member is provided in plural.

11. The semiconductor package device according to claim 1, wherein a plurality of electrical connection elements is disposed on a second surface of the redistribution layer member, the second surface being opposite the first surface.

12. The semiconductor package device according to claim 1, wherein the semiconductor package device has a fan-out package structure.

13. A method of manufacturing a semiconductor package device, the method comprising:
preparing a device structure comprising a redistribution layer member, a plurality of chips, and a molding layer, wherein the redistribution layer member has a plurality of unit device regions and has at least one electrical contact element around an active region for each of the plurality of unit device regions, the plurality of chips is disposed on a first surface of the redistribution layer member so as to be electrically connected to the redistribution layer member, the molding layer is disposed on the first surface of the redistribution layer member so as to expose a backside of each of the plurality of chips while filling spaces around the plurality of chips and has at least one through-hole configured to expose the at least one electrical contact element for each of the plurality of unit device regions;
forming a connection wiring member electrically connected to the at least one electrical contact element through the at least one through-hole and electrically connected to the backside of at least one of the plurality of chips on the molding layer for each of the plurality of unit device regions; and
dividing the device structure having the connection wiring member formed therein into package device units corresponding respectively to the plurality of unit device regions.

14. The method according to claim 13, wherein
the at least one electrical contact element is a single electrical contact element for each of the plurality of unit device regions, and
the single electrical contact element has a ring structure surrounding the active region.

15. The method according to claim 13, wherein the semiconductor package device is manufactured using a fan-out packaging method.
